# EUROPÄISCHE PATENTANMELDUNG

(11) **EP 1 852 959 A1**
(43) Veröffentlichungstag der Anmeldung: **07.11.2007**
(21) Anmeldenummer: 06009300.2
(22) Anmeldetag: 05.05.2006
(51) Int. Cl.: H02M 1/00, H02M 7/219, H02M 7/537

(54) **Stromversorgung für einen Mittelfrequenz-Plasmagenerator**

(71) Anmelder: HÜTTINGER Elektronik GmbH + Co. KG, 79111 Freiburg (DE)
(72) Erfinder: Richter, Volkhard, 47918 Tönisvorst (DE)
(74) Vertreter: Kohler Schmid Möbus

(57) **Zusammenfassung**

Bei einem MF-Plasmaleistungsgenerator (1) für einen Plasmaprozess mit einer DC-Stromversorgung (2), einem daran angeschlossenen Inverter (6), der zumindest ein an ein Stromversorgungspotential erster Polarität (11) angeschlossenes schaltendes Element (101, 102) aufweist, und einem Ausgangsnetzwerk (7), ist für jedes schaltende Element (101, 102) eine Entkoppelschaltung zur Entkopplung des schaltenden Elements (101, 102) von einer Spannung des Ausgangsnetzwerks (7) vorgesehen. Dadurch können die schaltenden Elemente (101, 102) verlustarm geschaltet werden.

## Beschreibung

Die Erfindung betrifft einen MF-Plasmaleistungsgenerator für einen (Vakuum-)Plasmaprozess mit einer DC-Stromversorgung, einem daran angeschlossenen Inverter, der zumindest ein an ein Stromversorgungspotential erster Polarität angeschlossenes schaltendes Element aufweist, und einem Ausgangsnetzwerk, sowie ein Verfahren zur Leistungsregelung und/oder -steuerung eines MF-Plasmaleistungsgenerators mit einem zumindest ein ansteuerbares schaltendes Element aufweisenden Inverter und einem Ausgangsnetzwerk im Pulsweitenmodulationsverfahren.

MF-Plasmaleistungsgeneratoren - auch MF-Stromversorgungen genannt - für MF-Plasmaprozesse, weisen üblicherweise zunächst einen AC/DC-Wandler auf, der die Netzwechselspannung zu einer geregelten oder ungeregelten Gleichspannung wandelt. Wenn eine Stromquellencharakteristik erwünscht ist, wird diese häufig durch nachgeschaltete Drosseln realisiert.

Es schließt sich dann ein Inverter an. Dem Inverter nachgeschaltet ist ein Ausgangsnetzwerk, das üblicherweise aus einem Schwingkreis besteht. Es kann sich dabei um einen Parallel- oder Serienschwingkreis handeln, der üblicherweise in der Nähe seiner Eigenresonanz betrieben wird.

Zur Leistungsregelung sind unterschiedliche Verfahren bekannt. Das überwiegend übliche Verfahren ist die Regelung der Gleichspannung oder des Gleichstroms. Der Vorteil dieses Verfahrens ist, dass die Frequenz des Ausgangssignals für den jeweiligen Anwendungsfall individuell eingestellt werden kann, da die Leistung nicht über die Frequenz geregelt wird. Trotzdem ist dieses Verfahren zur Leistungsregelung relativ aufwändig. Häufig müssen je nach Netzwechselspannung sowohl Hochsetzsteller als auch Tiefsetzsteller eingesetzt werden.

Eine Alternative stellt die Leistungsregelung über die Frequenzvariation dar. Da das Ausgangsnetzwerk eine Resonanzfrequenz besitzt, lässt sich die Leistung in diesem Ausgangsnetzwerk durch Annähern der Betriebsfrequenz an die Resonanzfrequenz erhöhen und umgekehrt erniedrigen.

Beim so genannten Phase-Shift-Verfahren werden schaltende Elemente des Inverters die maximal mögliche Einschaltdauer eingeschaltet, aber die Einschaltphasen der schaltenden Elemente werden so gegeneinander verschoben, dass Strom nur für einen Teil der Dauer einer Halbwelle in das Ausgangsnetzwerk fließen kann. Das Phase-Shift-Verfahren setzt eine Vollbrücke im Inverter voraus.

Ein weiteres Verfahren zur Leistungsreglung, das keine Vollbrücke voraussetzt, ist das Pulsweitenmodulationsverfahren (PWM), bei dem die schaltenden Elemente des Inverters nur für einen Teil der möglichen Einschaltdauer eingeschaltet werden. Auf diese Weise wird nur ein Teil der Leistung zum Ausgangsnetzwerk geführt. Dieses Verfahren hat den Vorteil, dass die Frequenz stabil (konstant) bleiben kann, was für viele Prozesse vorteilhaft ist.

Idealerweise entstehen an dem oder den schaltenden Elementen des Inverters keine Verluste, da im eingeschalteten Zustand die Spannung an dem oder den schaltenden Elemente gleich Null ist und im ausgeschalteten Zustand der Strom gleich null ist. Problematisch sind die Ein- und Ausschaltvorgänge. Beim Einschalten der schaltenden Elemente stört eine vorhandene Spannung, da das schaltende Element diese zunächst abbauen muss und bis dahin sowohl ein Strom fließt, als auch eine Spannung anliegt. Vorteilhaft ist hier ein so genanntes Null-Spannungs-Schalten (Zero-Voltage Switching ZVS), was durch eine entsprechende Strom-Spannungs-Phasenverschiebung erreicht werden kann.

Beim Ausschalten der schaltenden Elemente ist ein noch fließender Strom unerwünscht, weil auch dieser zu Verlusten in den Schaltern führt. Vorteilhaft ist hier ein so genanntes Null-Strom-Schalten (Zero-Current Switching ZCS). Auch dies kann durch entsprechende Strom-Spannungs-Phasenverschiebung erreicht werden. Sowohl ZVS als auch ZCS sind oft nur sehr aufwändig zu erreichen.

Die Verwendung des Pulsweitenmodulationsverfahrens bei Invertern, denen ein Ausgangsnetzwerk nachgeschaltet ist, gestaltet sich insbesondere deshalb als schwierig, da das Ausgangsnetzwerk die Spannung an den schaltenden Elementen des Inverters bestimmt.

Aufgabe der vorliegenden Erfindung ist es, daher, ein Verfahren und einen MF-Plasmaleistungsgenerator bereitzustellen, die die Verwendung des Pulsweitenmodulationsverfahrens zur Leistungsregelung bei geringen Verlusten ermöglicht.

Diese Aufgabe wird erfindungsgemäß durch einen MF-Plasmaleistungsgenerator der eingangs genannten Art gelöst, bei dem für jedes schaltende Element eine Entkoppelschaltung zur Entkopplung des schaltenden Elements von einer Spannung des Ausgangsnetzwerks vorgesehen ist, insbesondere einer zwischen den Eingangsanschlüssen des Ausgangsnetzwerks vorhandenen Spannung. Dabei kann es sich um eine vollständige oder eine teilweise Entkopplung von einer Spannung des Ausgangsnetzwerks handeln. Durch die Entkoppelschaltung ist es möglich, die an einem schaltenden Element anliegende Spannung beim Einschalten auf eine niedrige Spannung zu begrenzen, insbesondere auf etwa 0 V zu begrenzen. Dadurch können die schaltenden Elemente unabhängig von den aktuellen Betriebsparametern des MF-Plasmaleistungsgenerators sehr verlustarmen geschaltet werden. Das Ausgangsnetzwerk kann einen Schwingkreis aufweisen. Dabei kann es sich um einen Serienschwingkreis oder um einen Parallelschwingkreis handeln. Bestandteil des Schwingkreises kann ein Ausgangstransformator sein, dessen Streuinduktivität ein Teil der Induktivität des Schwingkreises sein kann. Ein Transformator kann auch unabhängig vom Schwingkreis zwischen Inverter und Ausgangsnetzwerk geschaltet sein. Mit einem (Ausgangs-)transformator ist der Ausgang des MF-Plasmaleistungsgenerators von einem Netzanschluss galvanisch getrennt. Zusätzlich kann ein Serienkondensator am Ausgang des MF-Plasmaleistungsgenerators vorgesehen sein, der die Symmetrie der Leistungsverteilung auf beiden Ausgangsleitungen verbessern kann.

Besonders vorteilhaft ist es, wenn die Entkoppelschaltung nicht-lineare und/oder aktive Bauelemente aufweist. Als nichtlineare Bauelemente kommen beispielsweise Dioden infrage. Alternativ sind Induktivitäten denkbar, die extern, beispielsweise durch eine Steuerung, beeinflusst werden oder bewusst in die Sättigung betrieben werden. Als aktive Bauelemente kommen beispielsweise Schalter infrage, die für vorbestimmbare Zeiten ein - und ausgeschaltet werden.

Bei einer bevorzugten Ausführungsform kann vorgesehen sein, dass die Entkoppelschaltung ein erstes Bauelement aufweist, das zwischen das schaltende Element und einen Eingangsanschluss des Ausgangsnetzwerks geschaltet ist, und ein zweites Bauelement aufweist, das zwischen das schaltende Element oder den Eingangsanschluss des Ausgangsnetzwerks und ein von dem Stromversorgungspotential erster Polarität verschiedenes Begrenzungspotential geschaltet ist. Das erste Bauelement kann dabei die Entkopplung des schaltenden Elements von der Spannung des Ausgangsnetzwerks durchführen. Das zweite Bauelement kann als Freilaufelement ausgebildet sein, so dass bei ausgeschaltetem (geöffnetem) schaltenden Element ein durch Induktivitäten, beispielsweise Leitungsinduktivitäten in der Leitung von dem Inverter zum Ausgangsnetzwerk, verursachter Strom weiterhin bei gleich bleibender Stromrichtung gezogen werden kann.

Bei einer bevorzugten Weiterbildung kann das erste Bauelement als Diode und das zweite Bauelement als Freilaufdiode ausgebildet sein. Dadurch ergibt sich eine besonders einfache und kostengünstige Realisierung des ersten und zweiten Bauelements.

Eine besonders einfache Ausgestaltung des erfindungsgemäßen MF-Plasmaleistungsgenerators ergibt sich, wenn das Begrenzungspotential ein Stromversorgungspotential zweiter Polarität ist. Dies bedeutet, dass das schaltende Element an einen Anschluss einer Stromversorgung, beispielsweise den positiven Anschluss, und das zweite Bauelement an den anderen Anschluss der Stromversorgung, beispielsweise den negativen Anschluss, angeschlossen werden können. Für das Begrenzungspotential ist kein weiterer Anschluss notwendig. Dadurch ergibt sich eine einfache Schaltung mit wenigen Bauteilen.

Vorteile ergeben sich jedoch auch bei einer alternativen Ausgestaltung, bei der das Begrenzungspotential betragsmäßig größer ist als das Stromversorgungspotential zweiter Polarität. Dadurch wird das zweite Bauelement, beispielsweise eine Freilaufdiode, auf eine betragsmäßig höhere Spannung gehoben. Somit kann der Inverter als Hochsetzsteller arbeiten. Die Spannung am Ausgangsnetzwerk kann also betragsmäßig größere Spannungswerte annehmen als die Spannung, mit der der Inverter gespeist wird. Damit bekommt der Generator einen erweiterten Steuer- bzw. Regelbereich.

Bei einer bevorzugten Ausführungsform kann für jedes schaltende Element eine Entlastungsschaltung vorgesehen sein. Dadurch kann die Spannung am schaltenden Elementen vor dem Einschalten auf etwa 0 V gebracht werden, ohne dabei die Spannung im Ausgangsnetzwerk deutlich zu beeinflussen.

Die Entlastung lässt sich besonders einfach realisieren, wenn die Entlastungsschaltung nicht-lineare und/oder aktive Bauelemente umfasst.

Weitere Vorteile ergeben sich, wenn die Entlastungsschaltung eine parallel zum schaltenden Element angeordnete Spannungsanstiegsverzögerungsanordnung, insbesondere einen Kondensator, aufweist. Dadurch wird das schaltende Element geschont und werden Verluste vermindert.

Bei einer bevorzugten Ausgestaltung der Erfindung kann vorgesehen sein, dass die Entlastungsschaltung ein erstes aktives Element, insbesondere einen Transistor aufweist, der zwischen das zu entlastende schaltende Element und das Stromversorgungspotential zweiter Polarität geschaltet ist. Dieses aktive Element kann ebenfalls verlustfrei eingeschaltet werden, wenn der Strom über die Freilaufdiode fließt, da dann an dem aktiven Element eine vernachlässigbare Spannung anliegt. Zwischen dem schaltenden Element und dem ersten aktiven Element können noch weitere Bauelemente vorgesehen sein, wie beispielsweise eine Diode.

Vorzugsweise weist die Entlastungsschaltung ein zweites aktives Element, insbesondere einen Transistor auf, das zwischen das zu entlastende schaltende Element und ein Bezugspotential geschaltet ist. Mithilfe dieses aktiven Elements kann ein parallel zum schaltenden Element angeordneter Kondensator umgeladen werden. Durch Einstellung der Zeitdifferenz zwischen dem Einschalten des zweiten aktiven Elements und des Ausschaltens des ersten aktiven Elements kann eingestellt werden, wie schnell und bis zu welcher Spannung der Kondensator umgeladen wird. Vorzugsweise wird diese Zeit so eingestellt, dass immer eine Umladung des Kondensators bis auf 0 V erfolgt. Auf diese Weise kann verlustarm geschaltet werden.

Das Bezugspotential liegt vorzugsweise in der Mitte zwischen den Stromversorgungspotentialen erster und zweiter Polarität. Das erste und zweite aktive Element können dabei MOSFETs oder IGBTs sein, die Ströme bis zu mehreren 100 Ampere schalten können.

Bei einer Weiterbildung kann vorgesehen sein, dass dem zweiten aktiven Element ein Netzwerk zugeordnet ist. Dieses Netzwerk kann beispielsweise eine Spule und eine Diode aufweisen. Mithilfe der Spule kann der Kondensator umgeladen werden und die Stromanstiegsgeschwindigkeit in den aktiven Elementen eingestellt werden.

Eine besonders einfache Realisierung einer DC-Stromversorgung ergibt sich, wenn die DC-Stromversorgung als Netzgleichrichter oder PFC-Glied ausgebildet ist, die jeweils an eine Netzwechselspannung angeschlossen sind. Dabei kann die erzeugte DC-Spannung sowohl eine feste geregelte Spannung sein als auch eine ungeregelte Spannung sein.

Der Inverter kann ein schaltendes Element, eine Halbbrücke mit zwei schaltenden Elementen oder eine Vollbrücke mit vier schaltenden Elementen aufweisen, wobei die schaltenden Elemente durch eine Steuerung angesteuert sind. Über die Steuerung kann die Pulsweite eingestellt werden.

In den Rahmen der Erfindung fällt außerdem ein Verfahren der eingangs genannten Art, wobei das schaltende Element von einer Spannung des Ausgangsnetzwerks, insbesondere der Spannung zwischen dessen Eingangsanschlüssen, zumindest weitestgehend entkoppelt wird, indem nach dem Öffnen des schaltenden Elements die Stromrichtung in Richtung Ausgangsnetzwerk aufrechterhalten wird und eine Stromrichtungsumkehr in dem schaltenden Element verhindert wird. Dadurch wird eine Entlastung des schaltenden Elements ermöglicht.

Bei einer bevorzugten Verfahrensvariante kann vorgesehen sein, dass das schaltende Element während seiner Schaltvorgänge entlastet wird, indem beim Öffnen des schaltenden Elements der Spannungsanstieg am schaltenden Element verzögert wird. Dadurch wird eine Reduzierung der Verluste beim Öffnen des schaltenden Elements ermöglicht.

Besonders vorteilhaft ist es, wenn das schaltende Element entlastet wird, indem die an ihm anliegende Spannung vor dem Schließen des schaltenden Elements reduziert wird, insbesondere auf etwa OV reduziert wird. Dadurch wird auch ein nahezu verlustfreies Schließen des schaltenden Elements ermöglicht.

Vorteilhafterweise kann das schaltende Element im Pulsgruppenmode betrieben werden. Dies erlaubt die Verwendung kleinerer Induktivitäten auch bei niedrigen Frequenzen.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: eine schematische Darstellung eines MF-Plasmaleistungsgenerators;
- **Fig. 2**: eine schematische Darstellung eines Teils eines MF-Plasmaleistungsgenerators mit einem Inverter, der ein schaltendes Elementen aufweist, ohne separates Begrenzungsspannungspotential;
- **Fig. 3**: eine schematische Darstellung eines Teils eines MF-Plasmaleistungsgenerators mit einem Inverter, der ein schaltendes Elementen aufweist, mit separatem Begrenzungsspannungspotential;
- **Fig. 4**: eine schematische Darstellung eines Teils eines MF-Plasmaleistungsgenerators mit einem Inverter, der zwei schaltende Elemente aufweist, ohne separates Begrenzungsspannungspotential;
- **Fig. 5**: eine schematische Darstellung eines Teils eines MF-Plasmaleistungsgenerators mit einem Inverter, der zwei schaltende Elemente aufweist, mit separatem Begrenzungsspannungspotential;
- **Fig. 6**: einen Schaltplan eines MF-Plasmaleistungsgenerators;
- **Fig. 7a - 7d**: zeitliche Verläufe von ausgewählten Signalen in der Schaltung gemäß Fig. 6.

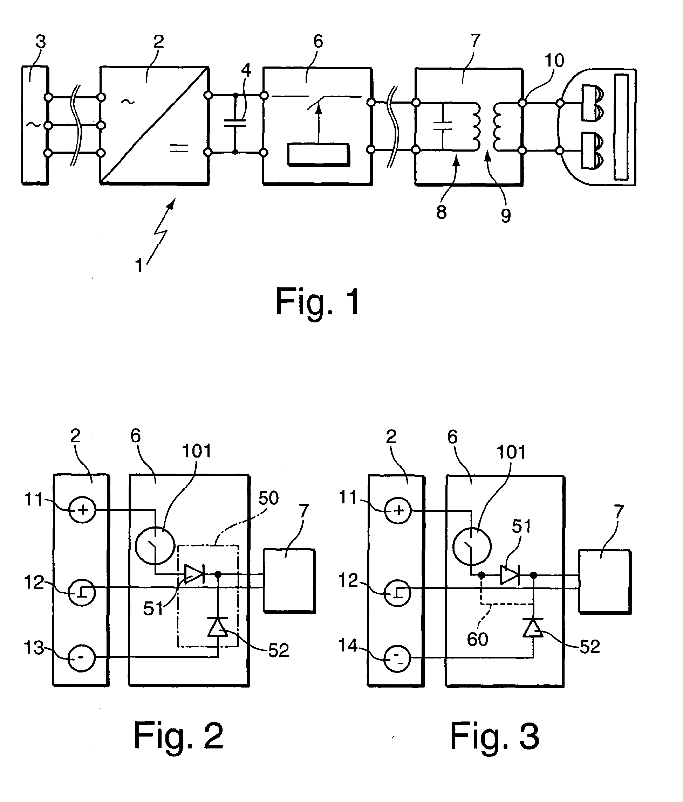

Der in der Figur 1 gezeigte MF-Plasmaleistungsgenerator 1 umfasst als DC-Stromversorgung 2 einen AC/DC - Wandler, der an ein Wechselspannungsnetz 3 angeschlossen ist. Ein Inverter 6 ist an die DC-Stromversorgung 2 angeschlossen. Ein Kondensator 4 kann zwischen die Anschlüsse der Stromversorgung 2 angeschlossen werden. Ein an den Inverter 6 angeschlossenes Ausgangsnetzwerk 7 umfasst einen Schwingkreis 8 und einen Ausgangstransformator 9, der den Ausgang 10 des MF-Plasmaleistungsgenerators 1 von dem Wechselspannungsnetz 3 galvanisch isoliert.

In der schematischen Darstellung der Figur 2 ist eine DC-Stromversorgung 2 gezeigt, an die der Inverter 6 angeschlossen ist. Der Inverter 6 weist ein schaltendes Element 101 auf, welches an ein Stromversorgungspotential erster Polarität 11 - hier dem gegenüber dem Bezugspotential 12 positiven Potential - angeschlossen ist. Bei geschlossenem schaltendem Element 101 kann ein Strom über das Ausgangsnetzwerk 7 zu dem Bezugspotential 12 fließen. Um das schaltende Element 101 von dem Ausgangsnetzwerk 7 zu entkoppeln, ist eine Entkoppelschaltung 50 vorgesehen. Die Entkoppelschaltung 50 umfasst ein erstes als Diode ausgebildetes Bauelement 51 und ein zweites als Diode ausgebildetes Baulement 52, welches eine Freilaufdiode darstellt. Das zweite Bauelement 52 ist an ein Stromversorgungspotential zweiter Polarität 13 angeschlossen.

Die Darstellung der Figur 3 entspricht im Wesentlichen der der Figur 2 mit dem Unterschied, dass das zweite Bauelement 52 an ein Begrenzungspotential 14 angeschlossen ist, welches betragsmäßig größer ist als das Stromversorgungspotential zweiter Polarität 13 - hier dem im Vergleich zum Bezugspotential 12 negativen Potential. Vorteilhafterweise wird das zweite Bauelement 52 nach dem ersten Bauelement 51 angeschlossen. Es kann alternativ aber auch vor dem ersten Bauelement 51 angeschlossen werden, was durch die gepunktete Linie 60 angedeutet wird.

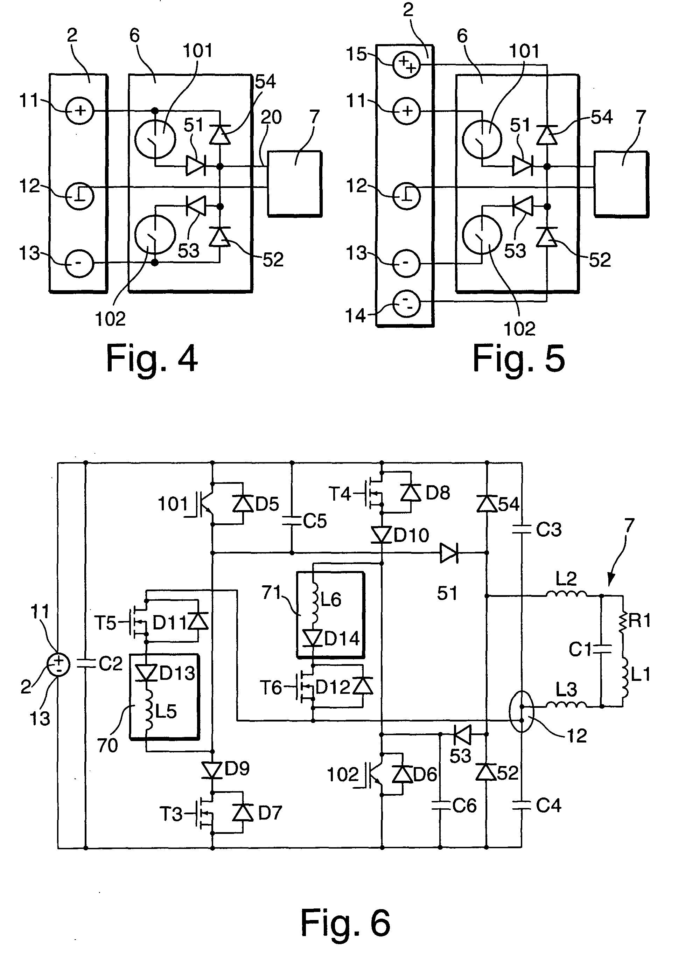

Bei der Ausführungsform der Figur 4 weist der Inverter 6 eine Halbbrücke mit zwei schaltenden Elementen 101, 102 auf. Dabei stellen das erste Bauelement 51 und das zweite Bauelement 52 die Entkopplungsschaltung für das erste schaltende Element 101 dar und stellen das erste Bauelement 53 und das zweite Bauelement 54 die Entkoppelschaltung für das schaltende Element 102 dar. Die zweiten Bauelemente 52, 54 sind jeweils an ein Stromversorgungspotential 11,13 angeschlossen, wobei für das schaltende Element 101 und die zugehörige Entlastungsschaltung das Stromversorgungspotential 11 das Stromversorgungspotential erster Polarität und das Stromversorgungspotential 13 das Stromversorgungspotential zweiter Polarität darstellt. Entsprechend stellt das Stromversorgungspotential 13 für das schaltende Element 102 und die zugehörige Entlastungsschaltung das Stromversorgungspotential erster Polarität und das Stromversorgungspotential 11 das Stromversorgungspotential zweiter Polarität dar.

Für eine Entlastung der schaltenden Elemente 101, 102, insbesondere für ein Null-Spannungs-Schalten, ist es vorteilhaft, wenn die Spannung an den schaltenden Elementen 101, 102 auf 0 V gebracht werden kann, ohne dabei die Spannung am Ausgangsnetzwerk 7 deutlich zu beeinflussen. Dazu ist es vorteilhaft, wenn das schaltende Element 101 mit dem ersten Bauelement 51 und das schaltende Element 102 mit dem ersten Bauelement 53 entkoppelt werden. Allerdings ziehen Induktivitäten, zumindest die Leitungsinduktivitäten der Leitungen zwischen dem Inverter 6 und dem Ausgangsnetzwerk 7, auch bei ausgeschaltetem schaltenden Element 101 weiterhin einen Strom. Deswegen sind die als Freilaufdioden ausgebildeten zweiten Bauelemente 52, 54 zwischen dem Eingangsanschluss 20 des Ausgangsnetzwerks 7 und den Stromversorgungspotentialen erster beziehungsweise zweiter Polarität 11, 13 vorgesehen. Beim Ausschalten des schaltenden Elements 101 kann so der Strom über das zweite Bauelement 52 geführt werden, beim Ausschalten des schaltenden Elements 102 kann so der Strom über das zweite Bauelement 54 geführt werden.

In analoger Weise zur Figur 3 sind in der Anordnung der Figur 5 Begrenzungspotentiale 14,15 vorgesehen, an die die zweiten Bauelemente 52, 54 angeschlossen sind. Durch diese Maßnahme wird es ermöglicht, den Inverter 6 als Hochsetzsteller zu betreiben.

In der Figur 6 ist ein Schaltbild eines Inverters 6 mit angeschlossenem Ausgangsnetzwerk 7 dargestellt, anhand dessen die Funktionsweise erläutert wird. Im Folgenden wird die Schaltentlastung für das schaltende Element 101 erklärt, für das schaltende Element 102 verläuft die Schaltentlastung analog.

Zum Zeitpunkt t₁, wird das schaltende Element 101 abgeschaltet, d.h. es wird geöffnet und ein Stromfluss durch das schaltende Element 101 wird unterbunden. Der Strom, der von den Leitungsinduktivitäten L2, L3 in den Leitungen zum Ausgangsnetzwerk 7 weiter gezogen wird, kommutiert zu der als Kondensator ausgebildeten Spannungsanstiegsverzögerungsanordnung C5 (z.B. 100nF). So wird ein schneller Anstieg der Spannung dU/dt am schaltenden Element 101 verhindert. Die Spannungsanstiegsverzögerungsanordnung C5 lädt sich auf bis das als Freilaufdiode ausgebildete zweite Bauelement 52 leitend wird. Nun kann das erste aktive Element T3 verlustfrei eingeschaltet werden, da auch hier die Spannung nahezu gleich 0 V ist. Der Strom durch die Leitungsinduktivitäten L2, L3 ist seit dem Ausschalten des schaltenden Elements 101 ständig gesunken, bis er schließlich 0 A beträgt. Zu diesem Zeitpunkt sinkt auch die Spannung über den Leitungsinduktivitäten L2 und L3 auf Null Volt. Das erste Bauelement 51 hat seit dem Zeitpunkt als das zweite Bauelement 52 leitend wurde und den Strom durch die Leitungsinduktivitäten L2, L3 geführt hat, Zeit gehabt, zu rekombinieren, da keine Spannung mehr anlag. Zu dem Zeitpunkt, wenn der Strom durch die Leitungsinduktivitäten L2, L3 seinen Nulldurchgang durchlaufen würde und es zu einer Stromrichtungsumkehr kommen würde, beginnen die Bauelemente 51, 52 zu sperren.

Das Folgende beschreibt die Beendigung der Sperrphase des schaltenden Elements 101. Das aktive Element T3 ist weiterhin geschlossen (leitend) und das zweite aktive Element T5 wird eingeschaltet (geschlossen). Dem zweiten aktiven Element T5 ist ein Netzwerk 70 zugeordnet, welches im Ausführungsbeispiel eine Diode D13 und eine Induktivität L5 aufweist. Der Strom in beiden aktiven Elementen T3, T5 steigt linear an (nicht unbedingt langsam, da L5= z.B. 250nH), da die Induktivität L5 in Reihe zum zweiten aktiven Element T5 geschaltet ist. Wenn genügend Energie für den folgenden Vorgang in der Induktivität L5 gespeichert ist, wird das erste aktive Element T3 ausgeschaltet und der Strom, getrieben von der Induktivität L5 lädt nun die als Kondensator ausgebildete Spannungsanstiegsverzögerungsanordnung C5 um. Der Umladevorgang ist eine Schwingung, die sich aus der Eigenresonanz des Schwingkreises mit den Elementen C5 und L5 ergibt. Daher ist die Schwingung sinusförmig.

Über die Zeitspanne zwischen dem Einschalten des zweiten aktiven Elements T5 und dem Ausschalten des ersten aktiven Elements T3 kann man steuern, wie schnell und bis zu welcher Spannung die Spannungsanstiegsverzögerungsanordnung C5 umgeladen wird. Vorteilhafterweise wird diese Zeit so eingestellt, dass unter allen Umständen die Umladung von C5 bis auf OV erfolgt. Überschüssige Energie wird dadurch abgebaut, dass die inhärente Diode D5 leitend wird. Sobald die Spannung an der Spannungsanstiegsverzögerungsanordnung C5 und damit am schaltenden Element 101 OV beträgt, wird das schaltende Element 101 nahezu verlustfrei eingeschaltet.

Mit Hilfe der im Ausführungsbeispiel gleich großen Kondensatoren C3 und C4 wird das Bezugspotential 12 generiert. Durch die DC-Stromversorgung 2 wird eine Zwischenkreisspannung UZ generiert, die zwischen den Stromversorgungspotentialen 11,13 liegt. Mit Kondensatoren C3, C4 gleicher Kapazität und mit einem Tastverhältnis, das für die schaltenden Elemente 101 und 102 die gleiche Dauer aufweist, kann bewirkt werden, dass das Bezugspotential 12 bei UZ/2 liegt.

Aufgrund der Spannungsdifferenz zwischen UZ und UZ/2 verringert sich der Strom in der Induktivität L5 immer weiter bis auf 0A, ab diesem Zeitpunkt sperrt die (schnelle) Diode D13. Ab diesem Zeitpunkt kann auch das zweite aktive Element T5 gesperrt werden.

Mit der Diode D9 wird verhindert, dass der Freilaufstrom anstatt über das zweite Bauelement 52 über das erste aktive Element T3, die Diode D7 oder das erste Bauelement 51 fließt.

Für das schaltende Element 102 sind zur Entlastung ein erstes aktives Elementen T4 und ein zweites aktives Element T6 mit zugeordnetem Netzwerk 71 vorgesehen.

Für die Entkopplung beziehungsweise Entlastung des ersten schaltenden Elements 101 sind das Stromversorgungspotential erster Polarität das Stromversorgungspotential 11 und das Stromversorgungspotential zweiter Polarität das Stromversorgungspotential 13. Für die Entkopplung beziehungsweise Entlastung des zweiten schaltenden Elements 102 sind das Stromversorgungspotential erster Polarität das Stromversorgungspotential 13 und das Stromversorgungspotential zweiter Polarität das Stromversorgungspotential 11.

Die Dioden D5, D6, D7, D8, D11, D12 sind die zu den schaltenden Elementen 101, 102 bzw. aktiven Elementen T3, T4, T5, T6 antiparallelen inhärenten Dioden.

Die aktiven Elemente T3, T4, T5, T6 dienen zusammen mit C5, C6 L5, L6 D13, D14, D9 und D10 zur Entlastung der schaltenden Elemente 101, 102, wobei T3, T5, C5, L5 und D13 eine Entlastungsschaltung für das schaltende Element 101 und T4, T6, C6, L6 und D14 eine Entlastungsschaltung für das schaltende Element 102 darstellen.

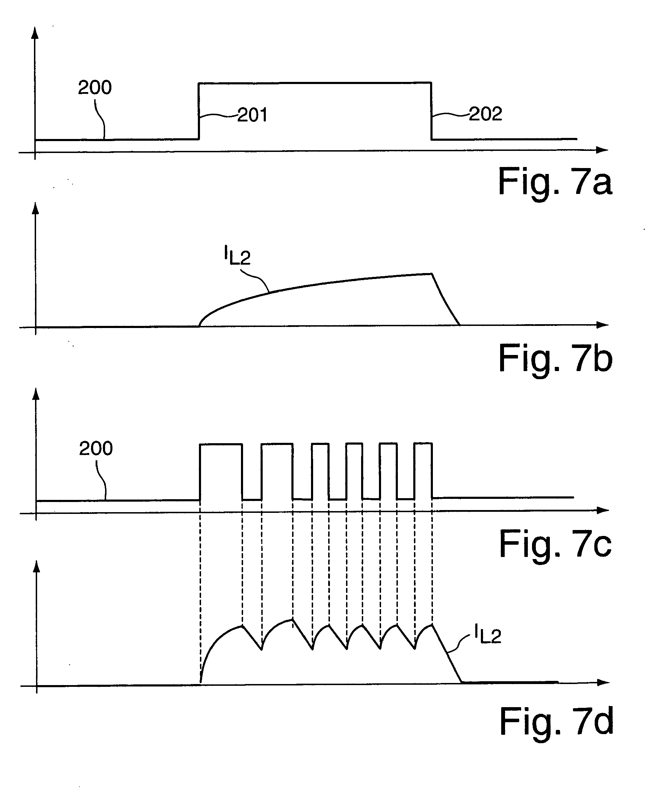

Anhand der Figuren 7a - 7d werden die Abläufe in der Figur 6 nochmals verdeutlicht. Die Figur 7a zeigt das Ansteuersignal 200 des schaltenden Elements 101. Bei der steigenden Flanke 201 wird das schaltende Element 101 geschlossen und bei der fallenden Flanke 202 wird das schaltende Element 101 geöffnet.

Die Figur 7b zeigt einen Strom I_{L2}, der sich als Folge des Ein- bzw. Ausschaltens des schaltenden Elements 101 in der Induktivität L2 einstellt. Beim Einschalten des schaltenden Elements 101 (steigende Flanke 201) steigt der Strom I_{L2} langsam an und fällt nach dem Ausschalten des schaltenden Elements 101 (fallende Flanke 202) wieder ab. Damit der Anstieg des Stroms nicht zu schnell erfolgt und der Strom besonders bei langen Einschaltdauern nicht über die Belastungsgrenzen der Bauteile steigt, müssen die Induktivitäten L2 und L3 ausreichend groß sein. Für niedrige Frequenzen müssen dazu evtl. große und teure Induktivitäten vorgesehen werden. Wenn dies nicht erwünscht ist, kann durch den Betrieb der schaltenden Elemente 101, 102 im Pulsgruppenmode auch für niedrige Frequenzen der gleiche Aufbau wie für hohe Frequenzen genutzt werden, und es können immer relativ kleine Induktivitäten L2, L3 genutzt werden. Einige Zeit nach dem Ausschalten (fallende Flanke 202) des ersten schaltenden Elements 101 wird das schaltende Element 102 eingeschaltet und es ergibt sich ein entsprechender Stromverlauf I_{L2}.

In der Figur 7c ist das Ansteuersignal 200 des schaltenden Elements 101 im Pulsgruppenmode gezeigt (während der Aus - Phasen bleibt auch das schaltende Element 102 geöffnet). Die entsprechende Reaktion des Stroms I_{L2} ist in der Figur 7d gezeigt. Die Induktivitäten L2 und L3 sind hier deutlich kleiner, was man an der größeren Steilheit der Kurven erkennt. Würde man diese Induktivitätswerte nutzen und das schaltende Element 101 die gesamte Zeit, wie in der Figur 7a eingeschaltet lassen, wäre ein Stromanstieg über die Grenzen zulässiger Betriebsbedingungen des Inverters möglich. Die Pulsdauer der einzelnen Pulse in der Pulsgruppe müssen nicht gleich lang sein, insbesondere ist es häufig vorteilhaft, die ersten Einschaltdauern länger zu wählen als die späteren, um den Strom I_{L2} schnell ansteigen zu lassen und dann über den Rest der Zeit in etwa konstant zu halten.

## Patentansprüche

1. MF-Plasmaleistungsgenerator (1) für einen Plasmaprozess mit einer DC-Stromversorgung (2), einem daran angeschlossenen Inverter (6), der zumindest ein an ein Stromversorgungspotential erster Polarität (11) angeschlossenes schaltendes Element (101, 102) aufweist, und einem Ausgangsnetzwerk (7), **dadurch gekennzeichnet, dass** für jedes schaltende Element (101, 102) eine Entkoppelschaltung (50) zur Entkopplung des schaltenden Elements (101, 102) von einer Spannung des Ausgangsnetzwerks (7) vorgesehen ist.

2. MF-Plasmaleistungsgenerator nach Anspruch 1, **dadurch gekennzeichnet, dass** die Entkoppelschaltung (50) nicht-lineare und/oder aktive Bauelemente aufweist.

3. MF-Plasmaleistungsgenerator nach Anspruch 1 oder 2, **dadurch gekennzeichnet, dass** die Entkoppelschaltung (50) ein erstes Bauelement aufweist, das zwischen das schaltende Element (51, 53) und einen Eingangsanschluss des Ausgangsnetzwerks (7) geschaltet ist, und ein zweites Bauelement (52, 54) aufweist, das zwischen das schaltende Element (101, 102) oder den Eingangsanschluss des Ausgangsnetzwerks (7) und ein von dem Stromversorgungspotential erster Polarität (11) verschiedenes Begrenzungspotential geschaltet ist.

4. MF-Plasmaleistungsgenerator nach Anspruch 3, **dadurch gekennzeichnet, dass** das erste Bauelement (51, 53) als Diode und das zweite Bauelement (52, 54) als Freilaufdiode ausgebildet sind.

5. MF-Plasmaleistungsgenerator nach Anspruch 3 oder 4, **dadurch gekennzeichnet, dass** das Begrenzungspotential ein Stromversorgungspotential zweiter Polarität (13) ist.

6. MF-Plasmaleistungsgenerator nach Anspruch 3 oder 4, **dadurch gekennzeichnet, dass** das Begrenzungspotential betragsmäßig größer ist als das Stromversorgungspotential zweiter Polarität (13).

7. MF-Plasmaleistungsgenerator nach einem der vorhergehenden Ansprüche, **dadurch gekennzeichnet, dass** für jedes schaltende Element (101, 102) eine Entlastungsschaltung vorgesehen ist.

8. MF-Plasmaleistungsgenerator nach Anspruch 7, **dadurch gekennzeichnet, dass** die Entlastungsschaltung nicht-lineare und/oder aktive Bauelemente umfasst.

9. MF-Plasmaleistungsgenerator nach Anspruch 7 oder 8, **dadurch gekennzeichnet, dass** die Entlastungsschaltung eine parallel zum schaltenden Element (101, 102) angeordnete Spannungsanstiegsverzögerungsanordnung (C5, C6), insbesondere einen Kondensator, aufweist.

10. MF-Plasmaleistungsgenerator nach einem der vorhergehenden Ansprüche 7 bis 9, **dadurch gekennzeichnet, dass** die Entlastungsschaltung ein erstes aktives Element (T3, T4), insbesondere einen Transistor aufweist, das zwischen das zu entlastende schaltende Element (101, 102) und das Stromversorgungspotential zweiter Polarität (11, 13) geschaltet ist.

11. MF-Plasmaleistungsgenerator nach einem der vorhergehenden Ansprüche 7 bis 10, **dadurch gekennzeichnet, dass** die Entlastungsschaltung ein zweites aktives Element (T5, T6), insbesondere einen Transistor aufweist, das zwischen das zu entlastende schaltende Element (101, 102) und ein Bezugspotential (12) geschaltet ist.

12. MF-Plasmaleistungsgenerator nach Anspruch 11, **dadurch gekennzeichnet, dass** dem zweiten aktiven Element (T5, T6) ein Netzwerk (70, 71) zugeordnet ist.

13. MF-Plasmaleistungsgenerator nach einem der vorhergehenden Ansprüche, **dadurch gekennzeichnet, dass** die DC-Stromversorgung (2) als Netzgleichrichter oder PFC-Glied ausgebildet ist.

14. MF-Plasmaleistungsgenerator nach einem der vorhergehenden Ansprüche, **dadurch gekennzeichnet, dass** der Inverter (6) ein schaltendes Element (101), eine Halbbrücke mit zwei schaltenden Elementen (101, 102) oder eine Vollbrücke mit vier schaltenden Elementen (101, 102) aufweist, wobei die schaltenden Elemente (101, 102) durch eine Steuerung angesteuert sind.

15. Verfahren zur Leistungsregelung und/oder -steuerung eines MF-Plasmaleistungsgenerators (1) mit einem zumindest ein ansteuerbares schaltendes Element (101, 102) aufweisenden Inverter (6) und einem Ausgangsnetzwerk (7) im Pulsweitenmodulationsverfahren, **dadurch gekennzeichnet, dass** das schaltende Element (101, 102) von einer Spannung des Ausgangsnetzwerks (7) zumindest weitestgehend entkoppelt wird, indem nach dem Öffnen des schaltenden Elements (101, 102) die Stromrichtung in Richtung Ausgangsnetzwerk (7) aufrecht erhalten wird und eine Stromrichtungsumkehr in dem schaltenden Element (101, 102) verhindert wird.

16. Verfahren nach Anspruch 14 oder 15, **dadurch gekennzeichnet, dass** das schaltende Element (101, 102) während seiner Schaltvorgänge entlastet wird, indem beim Öffnen des schaltenden Elements (101, 102) der Spannungsanstieg am schaltenden Element (101, 102) verzögert wird.

17. Verfahren nach einem der Ansprüche 14 bis 16, **dadurch gekennzeichnet, dass** das schaltende Element (101, 102) entlastet wird, indem die an ihm anliegende Spannung vor dem Schließen des schaltenden Elements (101, 102) reduziert wird, insbesondere auf etwa OV reduziert wird.

18. Verfahren nach einem der vorhergehenden Ansprüche 14 bis 17, **dadurch gekennzeichnet, dass** das schaltende Element (101, 102) im Pulsgruppenmode betrieben wird.
